# EUROPEAN PATENT APPLICATION

(11) **EP 4 715 819 A1**
(43) Date of publication of application: **25.03.2026**
(21) Application number: 24201151.8
(22) Date of filing: 18.09.2024
(51) Int. Cl.: G11C 11/16

(54) **NON-VOLATILE MEMORY WITH STACKED TRANSISTOR PAIR**

(71) Applicant: Imec VZW, 3001 Leuven (BE)
(72) Inventor: GARCIA REDONDO, Fernando, Cambridge, CB43NG (GB); ABDI, Dawit Burusie, 3001 Leuven (BE); SHARMA, Arvind Kumar, 3001 Heverlee (BE)
(74) Representative: EIP

(57) **Abstract**

A bit cell (100) is disclosed, comprising a non-non-volatile memory element (110) and a transistor arrangement (120) configured to provide a write signal switching a state of the memory element. A first terminal (111) of the memory element is connected to a bit line (BL), a second terminal (112) of the memory element is connected to a first common source/drain terminal (121) of the transistor arrangement, and a second common source/drain terminal (122) of the transistor arrangement is connected to a source line (SL). The transistor arrangement comprises a stacked complementary transistor pair, wherein a gate (213) of an upper transistor is connected to a first word line (WLN) and wherein a gate (223) of a lower transistor is connected to a second word line (WLP). A memory device comprising an array of such bit cells, as well as a method for controlling a bit cell, are also disclosed.

## Description

### Technical field

The present invention relates to a bit cell for a non-volatile memory (NVM), as well as a method for controlling such a bit cell.

### Background

NVM bit cells store information by changing the physical state of a memory element through a write signal, such as an electric current or voltage signal. For example, a magnetic random-access memory (MRAM) switches the magnetic orientation of a layer using current, while a resistive RAM (RRAM) changes material resistance with voltage.

Programming NVM cells typically involves switching the memory element between binary states ("0" and "1") through an access transistor that regulates the current or voltage applied to the memory element. In many NVM technologies, the programming process requires the write signal to flow in both directions, depending on whether the cell is being written with a "0" or a "1". This bidirectionality poses a challenge when using a single transistor, such as an NMOS transistor, as the access device. NMOS transistors are generally optimised to conduct current effectively in one direction. When current flows in the opposite direction, these transistors may operate in a "degenerated" mode, leading to slower programming and increased power consumption.

One approach to address these challenges is to use a complementary NMOS and PMOS transistor pair to handle bidirectional write signals more effectively. However, this approach increases the number of transistors per cell, increasing the footprint of each memory cell and reducing memory density.

Thus, there is a need for a bit cell design that supports fast programming while preserving high memory density.

### Summary

It is an object of the present disclosure to provide a bit cell for a NVM, that enables fast programming and an area efficient circuit design. Further and alternative objectives may be understood from the following.

According to a first aspect, there is provided a bit cell comprising a non-volatile memory element configured to be switchable between a first state and a second state, and a transistor arrangement configured to provide a write signal to the memory element to switch the memory element between the first state and the second state. The transistor arrangement comprises a stacked complementary transistor pair of an upper transistor and a lower transistor, wherein each transistor comprises a channel extending along a horizontal channel track. The channel of the lower transistor is arranged at a first level and the channel of the upper transistor being arranged at a second level, above the first level. A first source/drain terminal of the upper transistor is connected to a first source/drain terminal of the lower transistor to form a first common source/drain terminal of the transistor arrangement, whereas a second source/drain terminal of the upper transistor is connected to a second source/drain terminal of the lower transistor to form a second common source/drain terminal of the transistor arrangement. A first terminal of the memory element is connected to a bit line, a second terminal of the memory element is connected to the first common source/drain terminal of the transistor arrangement, and the second common source/drain terminal of the transistor arrangement is connected to a source line. Further, a gate of the upper transistor is connected to a first word line to allow the upper transistor to pass the write signal from the source line to the bit line, whereas a gate of the lower transistor is connected to a second word line to allow the lower transistor to pass the write signal from the bit line to the source line.

According to a second aspect, a memory device is provided, which comprises an array of bit cells according to the first aspect.

According to a third aspect, there is provided method for controlling a bit cell comprising a non-volatile memory element configured to be switchable between a first state and a second state, and a transistor arrangement configured to provide a write signal to the memory element to switch the memory element between the first state and the second state. The transistor arrangement comprises a stacked complementary transistor pair of an upper transistor and a lower transistor, each transistor comprising a channel extending along a horizontal channel track, the channel of the lower transistor being arranged at a first level and the channel of the upper transistor is arranged at a second level, above the first level. A first source/drain terminal of the upper transistor is connected to a first source/drain terminal of the lower transistor to form a first common source/drain terminal of the transistor arrangement, whereas a second source/drain terminal of the upper transistor is connected to a second source/drain terminal of the lower transistor to form a second common source/drain terminal of the transistor arrangement. A first terminal of the memory element is connected to a bit line, a second terminal of the memory element is connected to the first common source/drain terminal of the transistor arrangement, and the second common source/drain terminal of the transistor arrangement is connected to a source line. The method comprises applying a first write signal to a first word line, connected to a gate of the upper transistor, to pass the write signal from the source line to the bit line, and applying a second write signal to a second word line, connected to a gate of the lower transistor, to pass the write signal from the bit line to the source line.

According to a fourth aspect, there is provided a bit cell comprising a non-volatile memory element and an access transistor arrangement for controlling a write signal passing through the memory element, wherein the access transistor arrangement comprises a stacked complementary transistor pair of an upper transistor and a lower transistor. A channel of the lower transistor is arranged at a first level and a channel of the upper transistor is arranged a second level, above the first level.

By employing a complementary transistor pair as access devices, the bit cell may more effectively handle bidirectional write signals for programming the memory element. A first transistor of the pair may be an n-type transistor, effectively pulling the cell towards a low voltage state, while the second transistor may be a p-type transistor, effectively pulling the cell towards a high voltage state. This complementary configuration allows for a more robust switching performance compared to single-transistor configurations, which may require the transistor to operate in a degenerated mode depending on the direction of the write signal. As a result, programming times may be accelerated, and overall energy efficiency enhanced, making the bit cell more suitable for high-speed applications.

Furthermore, stacking the access transistors vertically on top of each other may reduce the lateral footprint of the bit cell. This vertical integration may help maximise the use of available area, allowing for higher memory density without sacrificing performance. By reducing the bit cell footprint, this approach may support the scaling down of integrated circuits and allow for the integration of larger memory arrays within a given area.

In some examples, both gates may be contacted from above, utilising word lines that extend in respective word line tracks arranged above the upper transistor. The word line tracks may extend at the same vertical level, such as a first metallisation layer. This approach may simplify the routing of word lines and may be advantageous in certain layouts where a uniform vertical level may be preferred for word line connections.

In other examples, the gates may be contacted from two different sides, with one gate being contacted from above and the other from below. In this arrangement, the first word line may extend in a first word line track arranged at a vertical level below the channel of the lower transistor, while the second word line may extend in a word line track positioned at a vertical level above the channel of the upper transistor. This dual-level word line configuration may provide greater flexibility in word line routing, reduce the risk for crosstalk and interference between adjacent cells, and allow for an improved scalability and density of NVM arrays.

The bit line and the source line may be arranged to contact the memory cell from the same side, such as from above or from below, or from opposite sides, depending on the design and operational requirements. Hence, in an example, each of the bit line and the source line extends is a respective power supply track that may be arranged on the same side of the transistor arrangement, i.e., above or below the transistor arrangement, such as at the same vertical level. In another example, a first one of the power supply tracks is arranged at a vertical level below the second one of the power supply tracks, whereas the second one of the power supply tracks is arranged at a vertical level above the channel of the upper transistor.

In some examples, the bit line and/or the source line may be formed as a buried power rail. The buried power rail may be formed by etching a recess or trench into the substrate on which the bit cell is formed, at a position below the lower transistor, and filling the recess or trench with an electrically conducting material. A via connection, such as a through-silicon via (TSV) may be provided to connect the power supply to the lower transistor.

In some examples, the upper transistor is an n-type transistor, and the lower transistor is a p-type transistor. In other examples, the upper transistor is a p-type transistor, whereas the lower transistor is an n-type transistor.

The complementary transistors may be field-effect transistors (FETs). Accordingly, the transistor arrangement may comprise a CMOS pair, formed of an nFET (n-type FET) and a pFET (p-type FET).

Each transistor may comprise a channel, formed of a semiconductor material, extending along a channel track, or fin track in case the transistor is a fin-based transistor, such as a fin-FET. The transistors may have channels extending along the same track, which may be understood as the horizontal geometrical line along which channel of a transistor is formed. The semiconductor channels may also be referred to as an elongated layer stack with a longitudinal dimension oriented along the substrate, in the channel track, and protruding vertically therefrom. Further, the semiconductor channel of one or both of the transistors may be formed in one or more horizontal semiconductor nanowires.

The gate may be understood as the electrode placed at the channel to control a conductivity of the channel. The gate may accordingly be configured as a gate-all-around gate, comprising an electrode completely enclosing/wrapping around an active portion of the channel, or channel region, of the respective one or more nanowires, or gate electrodes partly enclosing the channel region. The latter configuration may, for example, be the case in fork-sheet transistor designs.

A horizontal semiconductor nanowire may here refer to a semiconductor structure extending horizontally along the substrate and being suspended above the substrate. The nanowire may form a semiconductor body having a closed circumferentially extending boundary surface. Various lateral aspect ratios are possible, such as a width to height ratio close to unity, or a width to height ratio greater than one (such as a horizontally oriented non-sheet semiconductor structure) or smaller than one (such as a vertically oriented nano-sheet).

The source/drain regions of the transistors may refer to the physical portions of the semiconductor structure, which have been formed by epitaxy on end surfaces of the channel (such as nanowire) at either side of each gate, and which have been doped to create n-type or p-type regions. The source and drain regions of the transistors may hence be formed in opposite ends of the channel.

The source/drain terminals of the transistors may refer to the external connections that provide electrical access to the source/drain regions. The source/drain terminals may, in some examples, include a source/drain contact, which may comprise a layer of conductive material creating a low-resistance path between the source/drain regions and the source/drain terminals. The source/drain terminals completely or partly enclose/wrap around the source and drain regions of the channel.

It should be noted that relative spatial terms such as "vertical", "upper", "above", "lower", "below", "stacked on top of' are to be understood as denoting locations or directions in relation to a normal direction of a substrate, or in relation to a bottom-up direction of the device layer stack. Correspondingly, terms such as "lateral" and "horizontal" are to be understood as locations or directions parallel to the substrate, i.e., parallel to an upper surface or the main plane of extension of the substrate.

The bit cell may comprise various types of non-volatile memory elements. The memory element may be a resistive memory element, storing data by changing its electrical resistance. In some examples, the memory element comprises a magnetic tunnel junction (MTJ) element. MTJ elements may typically be employed in magnetic random-access memory (MRAM).

An MTJ element may comprise a layer stack of a first and a second ferromagnetic layer separated by a thin insulting layer. The MTJ element may be switched between two different resistance states (e.g., higher and lower resistance state) by changing the relative orientation of the magnetisation between first and second magnetic layers. Typically, the magnetisation of a first one of the layers, referred to as a free layer, is switched while the magnetisation of the second layer, referred to as a fixed or reference layer, is maintained.

The MTJ element may rely on the spin-transfer torque (STT) effect for writing the MTJ element. In STT-based switching, the state may be switched by passing a switching current, provided by the write signal, in an out-of-plane direction (e.g., bottom-up or top-down) through the MTJ layer stack.

More advanced configurations may be employed to provide faster switching speeds and reduce the energy required for writing. An example is the spin-orbit torque (SOT) MTJ element, which utilises the spin-orbit torque effect to switch the magnetisation state of the MTJ. In this configuration, the MTJ element comprises a SOT track, or SOT layer, that is arranged above or below the MTJ layer stack and configured to switch a state of the MTJ element as the write signal passes through the SOT track. The SOT track may be formed of a heavy metal layer and may be laterally extended outside the footprint of the MTJ layer stack to provide contact portions at mutually opposite sides thereof. By passing a current through in an in-plane direction through the SOT track, a spin current may be generated, which exerts a torque on the magnetisation.

The voltage-gate spin-orbit torque (VGSOT) MTJ element is another example, which combines the SOT switching mechanism with an additional voltage over the MTJ layer stack to further enhance switching efficiency and reduce power consumption. In this configuration, the MTJ element comprises a SOT track similar to the SOT configuration described above. By applying a voltage across the MTJ element, the energy barrier that must be overcome to switch the magnetisation of the free layer may be affected. By lowering the energy barrier, is may be easier to switch the free layer's magnetisation using spin currents induced by the SOT track.

### Brief Description of Drawings

The above, as well as additional objects, features, and advantages, may be better understood through the following illustrative and non-limiting detailed description, with reference to the appended drawings. In the drawings, like reference numerals will be used for like elements unless stated otherwise.
Figure 1 is a schematic layout of a bit cell comprising a transistor arrangement and a non-volatile memory element.
Figures 2A and B show horizontal cross sections of a transistor arrangement, taken at two different vertical levels.
Figures 2C and D show vertical cross sections through the transistor arrangement.
Figure 3 show vertical cross sections through a transistor arrangement according to another example.
Figure 4 is a schematic layout of a bit cell in which the non-volatile memory element comprises an SOT assisted MTJ element.

### Detailed Description

Bit cells for a non-volatile memory, arranged on a semiconductor substrate, along with methods for controlling these bit cells, will be described in the following with reference to the figures.

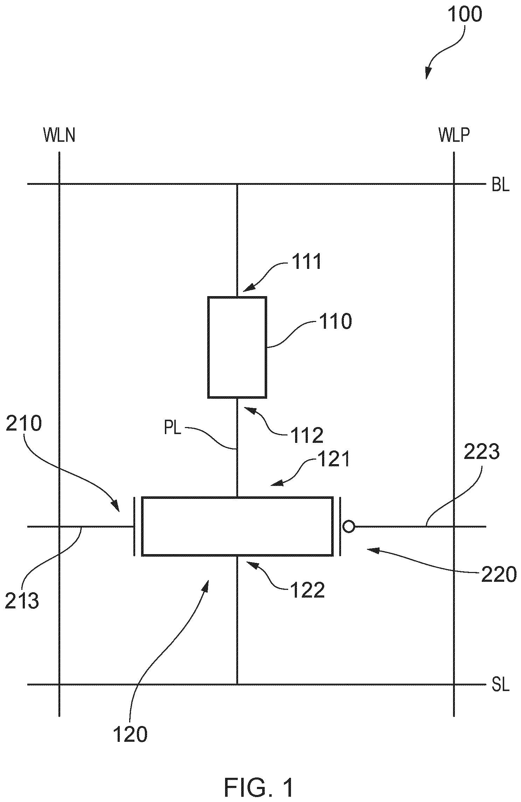

Figure 1 illustrates an example bit cell 100 in the form of a circuit schematic. The bit cell 100 comprises a non-volatile memory (NVM) element 110, which may be configured to be switchable between a first state and a second state to store data, typically as a logic "0" and a logic "1". The act of changing the state of the NVM element 110 may be referred to as programming or writing the NVM element 110. The programming of the NVM element 110 may be achieved by means of a write signal, such as an electric current, which may pass through NVM element 110. The write signal may be provided by a potential difference between a source line SL and a bit line BL. The write signal is typically controlled by a transistor arrangement 120, also referred to as an access transistor arrangement or access device, which may be arranged between the NVM element 110 and one of the source line SL and bit line BL. The transistor arrangement 120 may be controlled by a first word line WLN and a second word line WLP.

In the present example, a first terminal 111 of the NVM element 110 is connected to the BL and a second terminal 112 connected a program line PL, extending between the second terminal 112 and a first common source/drain terminal 121 of the transistor arrangement. A second common source/drain terminal 122 of the transistor arrangement 120 is connected to the source line SL, thereby allowing a signal path between the source line SL and the bit line BL, and hence through the program line PL and the NVM element 110, to be controlled by the transistor arrangement 110.

The non-volatile memory element 110 may, for example, be a resistive memory element. Examples include, but are not limited to, magnetic tunnel junction (MTJ) elements, resistive random-access memory (RRAM) elements, phase-change memory (PCM) elements, conductive-bridge RAM (CBRAM) elements, and ferroelectric tunnel junction (FTJ) elements.

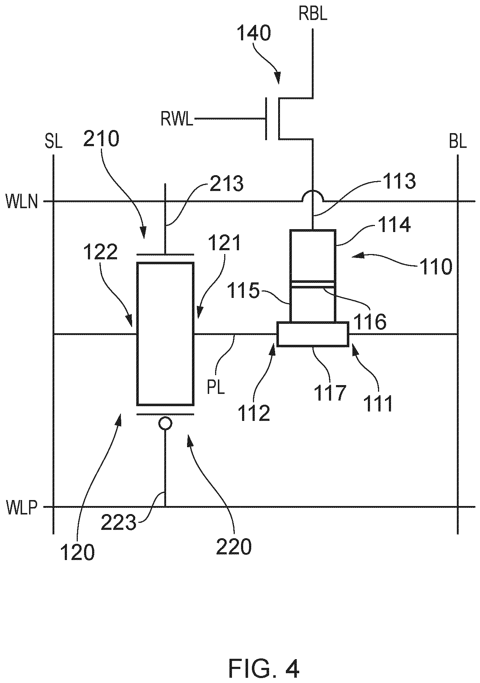

In the present example, the NVM element 110 comprises an MTJ element that includes two ferromagnetic layers separated by a thin insulating barrier, typically formed of magnesium oxide. The magnetisation of one layer (the free layer) can be switched between parallel and antiparallel orientations relative to the other layer (the fixed layer), which affects the electrical resistance through the layer stack. Data may be stored based on the resistance state: low resistance when the layers are parallel (representing, e.g., a "0") and high resistance when antiparallel (representing, e.g., a "1"). The switching may be achieved through spin-transfer torque (STT) or spin-orbit torque (SOT) mechanisms, as is discussed in further detail below with reference to figure 4.

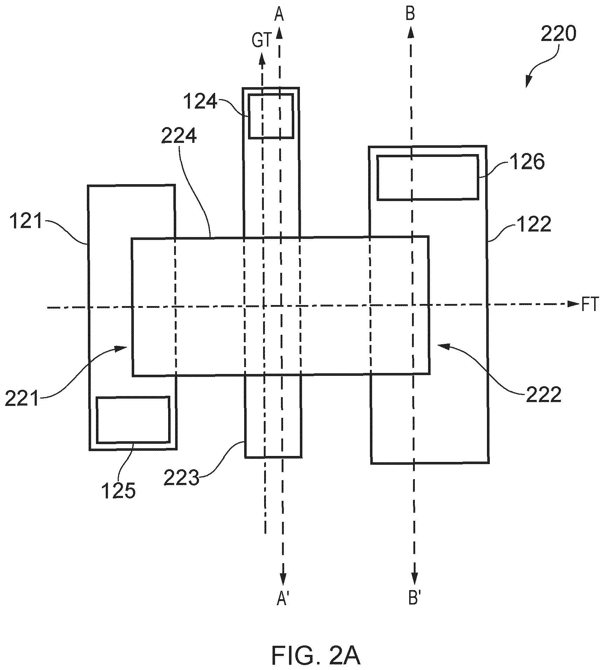

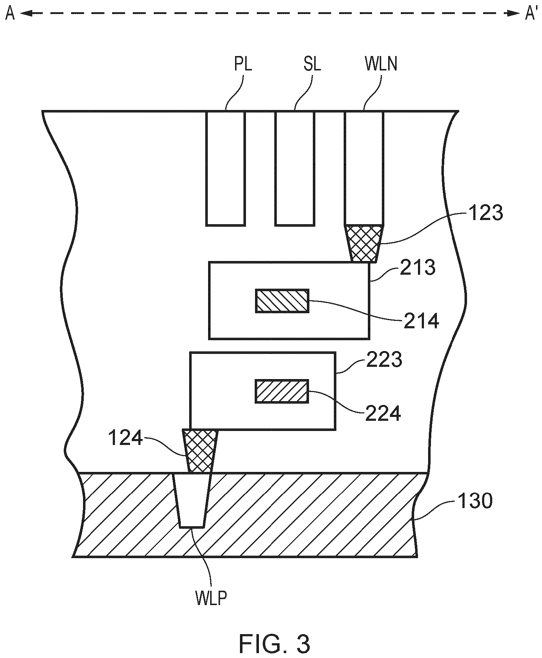

The transistor arrangement 120 comprises a stacked complementary transistor pair of an upper transistor 210 and a lower transistor 220. A gate 213 of the upper transistor 210 is connected to the first word line WLN to allow the upper transistor to pass the write signal from the source line SL to the bit line BL, whereas a gate 223 of the lower transistor is connected to the second word line WLP to allow the lower transistor to pass the write signal in the opposite direction, from the bit line BL to the source line SL. A more detailed discussion about the vertical design of the transistor arrangement 120 is provided in connection with figures 2A-D and 3.

The upper transistor 210 may be an NMOS (n-type metal-oxide-semiconductor) transistor, and the lower transistor 220 may be a PMOS (p-type metal-oxide-semiconductor) transistor, thus forming a complementary transistor pair. The source/drain terminals of this complementary transistor pair may be interconnected to form a first common source/drain terminal 121 and a second common source/drain terminal 122. The transistors 210, 220 may however be controlled separately by the respective word lines WLN, WLP. In the present example, the NMOS transistor 210 is controlled by the first word line WLN (n-type word line), while the PMOS transistor 220 is controlled by the second word line WLP (word line p-type).

The complementary transistor arrangement 120 allows the bit cell 100 to handle bidirectional write signals for programming NVM elements 110, such as MTJ elements. The NMOS transistor 210 allows the bit line BL to be pulled towards a low voltage (ground), while the PMOS transistor 220 allows the bit line BL to be pulled towards a high voltage (V_{DD}).

Writing a "1" to the NVM element may involve pre-charging or setting the bit line BL to its default state as required by the circuit design and activating the second word line WLP to turn on the PMOS transistor 220. When the second word line WLP is activated (low voltage for PMOS), the PMOS transistor becomes conductive, creating a path for the write signal through the NVM element 110. In some examples, the first word line WLN may be activated simultaneously to increase the current flow. With the second word line WLP activated and the PMOS transistor 220 on, a write current may flow from the high-voltage bit line BL through the NVM element 110, then to the program line PL and further to the source line SL. This current may cause the NVM element 110 to switch resistive state. In case of an MTJ element 110, the current may cause the magnetisation of the MTJ's free layer to align in parallel with the fixed layer, writing a "1" (low-resistance state). Once the desired state is written, the second word line WLP may be deactivated to turn off the PMOS transistor 220 and stop the programming current.

Writing a "0" to the NVM element 110 may include pre-charging the bit line BL to its appropriate initial state and activating the first word line WLN to turn on the NMOS transistor 210. When the first word line WLN is activated (high voltage for NMOS), the NMOS transistor 210 may become conductive, creating a path for the write signal through the NVM element 110. In some examples, the second word line WLP may in be activated simultaneously to increase the total current flow. With the first word line WLN activated and the NMOS transistor 210 on, a current may flow from the source line SL through the NMOS transistor 210 and into the NVM element 110 via the program line PL. The direction of the current may cause the resistive state of the NVM element 110 to switch. In case of an MTJ element 110, the current may cause the magnetisation of the free layer to switch to an orientation antiparallel with the fixed layer, writing a "0" (high-resistance state). Once the desired state is written, the first word line WLN can be deactivated to turn off the NMOS transistor 210 and stop the programming current.

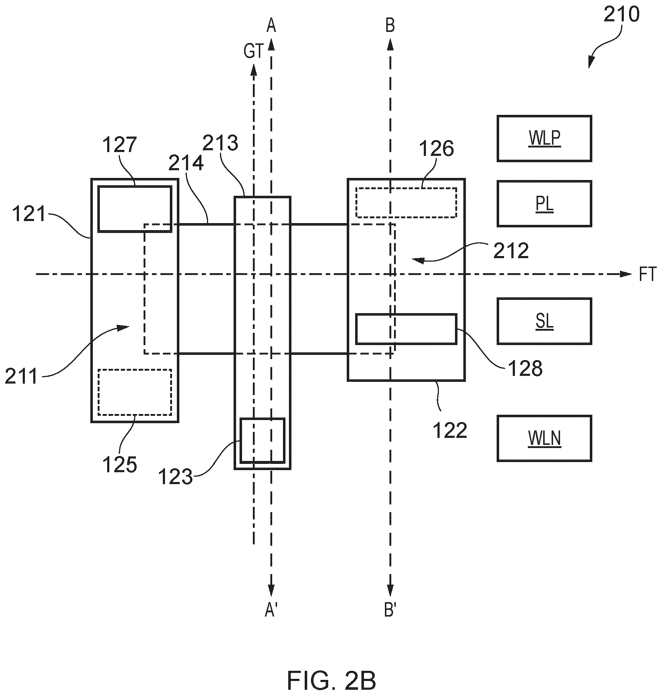

Figures 2A and B are schematic horizontal cross sections of a transistor arrangement 120, taken at different vertical levels. This transistor arrangement 120 may be configured similarly to the one shown in figure 1.

Figure 2A illustrate a cross section at a first, lower level (i.e., closer to the substrate on which the transistor arrangement 120 is formed), whereas figure 2B shows a cross section at a second, upper level, positioned above the first level. The transistor arrangement 120 comprises a lower transistor 220 arranged at the lower level (figure 2A) and an upper transistor 210 arranged at the upper level (figure 2B). Together, these transistors 210, 220 form a complementary transistor pair, vertically stacked and aligned such that their respective horizontal channels 214, 224 extend along the same geometric track, referred to as the channel track FT. This channel track FT represents a geometric track or geometric plane along which the channels 214, 224 are formed. Since the channels 214, 224 may be formed of a fin structure, the channel track FT may also be known as a fin track.

The channel 214 of the upper transistor 210 may extend horizontally between a source region and a drain region, which may be electrically contacted by first and second source/drain terminals 211, 212 of that transistor 210. Similarly, the channel 224 of the lower transistor 220 may extend horizontally between its source/drain regions, which may be electrically contacted by first and second source/drain terminals 221, 222 of that transistor 220.

The semiconductor channels 214, 224 may be formed of an elongated layer stack with a longitudinal dimension oriented along the substrate, in the channel track FT, and protruding vertically therefrom. Each channel 214, 224 may be formed of one or more nanowires or nanosheets, which may be formed from a layer stack of a fin structure. Each channel 214, 224 may be partly or completely enclosed by gate electrodes forming the respective gates 213, 223. In the present example, the transistor channels 214, 224 and source/drain terminals 211, 212, 221, 222 of the transistors 210, 220 may be formed in nanowire-shaped semiconductor structures extending horizontally along the substrate and being suspended above the substrate.

Various lateral aspect ratios of the semiconductor structures, such as a width to height ratio close to unity, or a width to height ratio greater than one (such as a horizontally oriented non-sheet semiconductor structure) or smaller than one (such as a vertically oriented nano-sheet).

The source and drain regions of the transistors 210, 220 may be formed in opposite ends of the semiconductor structures forming the channels 214, 224. Source and drain terminals 211, 212, 221, 222 of the transistors 210, 220 may completely enclose/wrap around the source and drain regions of the semiconductor structures. In this configuration, vertically aligned source/drain terminals are electrically connected, creating common source/drain terminals 121, 122 for both transistors 210, 220, as shown in the circuit schematic in figure 1. Vertically aligned source/drain terminals of the respective transistors 210, 220 may be connected by means of vertical interconnect structures. Specifically, the source/drain terminals 211, 221 on the left side of figures 2A and B are interconnected by a first source/drain via structure 125, thereby forming the first common source/drain terminal 121 of the complementary transistor pair. Similarly, the source/drain terminals 212, 222 on the right side of figures 2A and B are interconnected by a second source/drain via structure 126, creating the second common source/drain terminal 122 of the transistor pair.

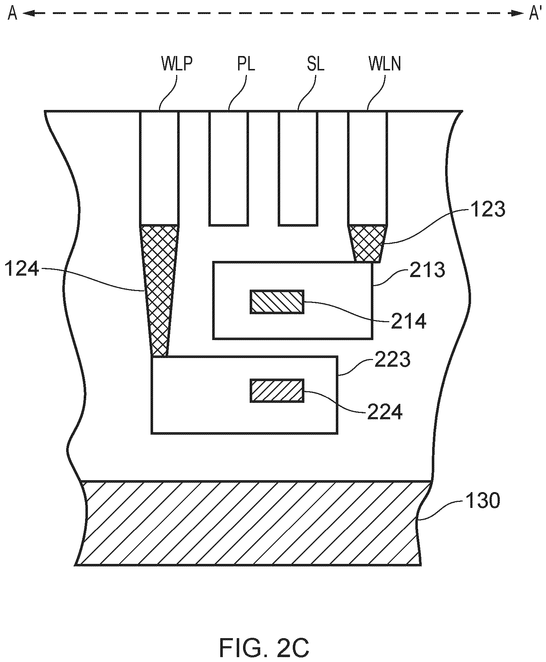

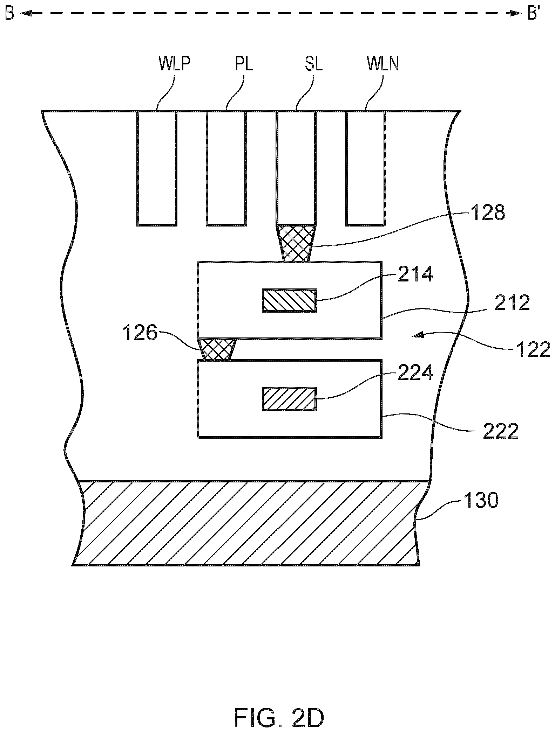

Figure 2B also indicates the tracks for the signal lines, i.e., the first and second word lines WLN, WLP and the power supply lines, i.e., the source line SL and the program line PL discussed above. In the present example, the signal lines are arranged in a metal layer M1 arranged above the upper transistor 210. The program line PL (connecting the memory element to the transistor structure 120) contacts the first common source/drain terminal 121 through a PL via structure 127, whereas the source line SL contacts the second terminal 122 through a SL via structure 128. Further, gate via structures 123, 124 connects the first and second word lines WLN, WLP to the respective gates 213, 223, as shown in figures 2C and D.

The vertical interconnect structures 125, 126, 127, 128 may be through-silicon via structures or other interconnect structures known in the art.

A gate track GT is also indicated, which extends transverse to and across the channel track FT. Similar to the channel track FT, the gate track GT may represent a geometric track or geometric line along which the gate electrodes of the gates 213, 223 of the bit transistor arrangement 110 may be distributed. The gate electrodes may be formed in a respective gate trench in one or more dielectric layer embedding the transistor arrangement 110. Accordingly, the gate track GT may be understood as representing the longitudinal direction of the gate trenches in which the gate electrodes are formed.

Figures 2C and D are vertical cross sections along the lines A-A' and B-B' indicated in figures 2A and B, that is, orthogonally through the gates 213, 223 of the transistor pair (figure 2C) and through the second source/drain terminals 212, 222 forming the second common source/drain terminal 122 of the transistor pair (figure 2D). The channel 214 of the upper transistor 210 is arranged above the channel 224 of the lower transistor 220, which in turn is arranged above the substrate 130.

Figure 2C is a vertical cross section through the gates 213, 223 of the upper transistor 210 and the lower transistor 220. The gates 213, 223 are electrically separated from each other, for example by means of a dielectric layer arranged therebetween, to allow the upper and lower transistor 210, 22 be controlled independently from each other. This is achieved by activating the respective word lines, such as the first word line WLN contacting the gate 213 of the upper transistor 210 and the second word line WLP contacting the gate 223 of the lower transistor. As shown in figure 2C, the word lines WLN, WLP may be connected to the respective gates 213, 223 through vertical interconnect structures extending between the metal layer and the respective transistors 210, 220. The gate 213 of the upper transistor 210 may be connected to the first word line WLN through a first gate via structure 123, whereas the gate 223 of the lower transistor 220 may be connected to the second word line WLP through a second gate via structure 123.

Figure 2D is a vertical cross section through the second common source/drain terminal 122 of the upper and the lower transistors 210, 220. The source/drain terminals 212, 222, in the present example wrapping around the end portions of the channels 214, 224 of the respective transistors 210, 220, are electrically connected by a vertical interconnect structure 126 extending between the upper and lower transistors 210, 220.

Figure 3 is a schematic cross section of a transistor arrangement 120, which may be configured similarly to the transistor arrangement 120 shown in figures 2A and B. The cross section in figure 3 is taken vertically along line A-A', through the gates 213, 223 of the transistor pair.

The present example however differs in that one of the word lines WLN, WLP, in this case the second word line WLP, contacts the transistor arrangement 120 from below, i.e., from a vertical level below the channel 224 of the lower transistor 220. The second word line WLP may be buried in a subsurface layer of the substrate 130 to connect the gate 223 through gate via structure 124, which extends vertically between the gate 223 and the second word line WLP. The second word line WLP may be formed by etching a recess or trench into the substrate 130, at a position below the lower transistor 220, and filling the recess or trench with an electrically conducting material.

Various configurations are possible. In some examples, one of the first and second word lines WLN, WLP is arranged below the second transistor 210, in other examples both word lines WLN, WLP contacts the respective transistors 210, 220 from below. In further examples, one or both of the program line PL and the source line SL are arranged in power rails buried in the substrate 130.

Figure 4 is a circuit schematic illustrating an example bit cell 100, which may be similar to the bit cell discussed above in connection with figure 1. However, in the present example, the memory element 110 comprises a spin-orbit torque (SOT) assisted MTJ element. The MTJ element includes a magnetic reference layer 114, a magnetic free layer 115, and a barrier layer 116 separating the reference layer 114 and the free layer 115. The MTJ element is arranged on a SOT track 117, which is configured to provide a write current for switching a magnetisation direction of the magnetic free layer 115 through SOT. The SOT track 117 comprises a heavy metal layer including, e.g., platinum, tantalum, tungsten, or bismuth-antimony telluride. The switching of the magnetisation in the magnetic free layer 115 may thus be mediated by SOTs which may be generated by conduction of the write signal through the heavy metal layer. The write signal may be controlled by the transistor arrangement 120, comprising a complementary pair of pass transistors 210, 220, arranged to control a signal path between the source line SL and the bit line BL.

In the present example, the first terminal 111 of the SOT track 117 is connected to the bit line BL, whereas the second terminal 112 of the SOT track 117 is connected to the program line PL. The program line PL, in turn, is connected to the first common source/drain terminal 121 of the transistor arrangement 120. This allows the transistor arrangement 120 to pass the write signal between the source line SL and the bit line BL, through the program line PL and the SOT track 117.

To program the MTJ element, the write signal is driven through the heavy metal layer adjacent to the free layer 115 of the MTJ element, generating SOT. To write a "1", the second word line WLP may be activated, turning the on the PMOS transistor 220. This creates a conductive path for the write signal from the bit line BL through the SOT track 117 and the program line PL to the PMOS transistor 220 and then to the source line SL. This current flow generates a spin current due to the spin Hall effect in the heavy metal layer, exerting a SOT on the MTJ element's free layer 115 and aligning its magnetisation parallel to the fixed layer. To write a "0", the first word line WLN may be activated, turning on the NMOS transistor 210. This action creates a conductive path from the source line SL through the NMOS transistor 210 to the program line PL and then through the SOT track 117 to the bit line BL. This reverse direction current also generates a spin current, which interacts with the MTJ element's free layer to switch its magnetisation into an antiparallel orientation relative to the fixed layer.

Reading the stored data may involve utilising a read bit line RBL and a read word line RWL. The read operation may begin by activating the read word line RWL. The read word line RWL is a control signal line connected to the gate of a read access transistor 140. By activating the read word line RWL, the transistor 140 is turned on, allowing it to connect a top terminal 113 of the MTJ element to the read bit line RBL. This establishes a conductive path between the MTJ element and the read bit line RBL, which typically is pre-charged to a known voltage level before the read operation. When the MTJ element is connected to the read bit line RBL, the voltage or current flowing through the read bit line may change depending on the resistance state of the MTJ element (such as low resistance for a "1" and high resistance for a "0"). A sense amplifier connected to the read bit line RBL may detect the voltage drop caused by the resistance of the MTJ element. If the MTJ element is in a low-resistance state, the current flow may cause a smaller voltage drop, resulting in a relatively higher voltage on the read bit line RBL. Conversely, if the MTJ element is in a high-resistance state, the current flow may cause a larger voltage drop, resulting in a lower voltage on the read bit line RBL.

After the read operation is completed, the read bit line RWL may be deactivated to turn off the read access transistor 140.

While the description herein references an SOT-assisted MTJ element as an example of a bit cell implementation, it is understood that the disclosure is not limited to this specific type of memory device. The principles and configurations described herein can be applied to bit cells employing other types of memory elements, such as those utilising voltage-gate spin-orbit torque (VGSOT) mechanisms. VGSOT combines the effects of SOT with an additional voltage gate that modulates the switching process. By applying a gate voltage, the magnetic anisotropy of the MJT element's free layer 115 may be controlled. The gate electrode can be either directly above or below the MTJ element, depending on the design, and is separated from the MTJ by an insulating layer. This configuration allows the gate voltage to influence the free layer 115 without directly passing current through it.

Although reference herein is made to "drain region"/"source region", "drain contact"/"source contact", and "drain terminal"/"source terminal" of a transistor, it should be noted that the actual function of the region/contact/terminal may depend on the direction of the current flowing through the transistor. Hence, "drain" and "source" may be construed broadly as mere labels for the two different regions/contacts/terminals of a transistor. Reference to a "drain" of a transistor may hence be interpreted as reference to a "first source/drain" terminal of the transistor and reference to a "source" of the transistor as a reference to a "second source/drain" terminal of the transistor.

## Claims

1. A bit cell (100), comprising:
a non-volatile memory element (110) configured to be switchable between a first state and a second state; and
a transistor arrangement (120) configured to provide a write signal to the memory element to switch the memory element between the first state and the second state;
wherein the transistor arrangement comprises a stacked complementary transistor pair of an upper transistor (210) and a lower transistor (220), each transistor comprising a channel (214, 224) extending along a horizontal channel track (FT), the channel of the lower transistor being arranged at a first level and the channel of the upper transistor being arranged at a second level, above the first level;
wherein a first source/drain terminal (211) of the upper transistor is connected to a first source/drain terminal (221) of the lower transistor to form a first common source/drain terminal (121) and a second source/drain terminal (212) of the upper transistor is connected to a second source/drain terminal (222) of the lower transistor to form a second common source/drain terminal (122);
wherein a first terminal (111) of the memory element is connected to a bit line (BL), a second terminal (112) of the memory element is connected to the first common source/drain terminal and the second source/drain terminal is connected to a source line (SL);
wherein a gate (213) of the upper transistor is connected to a first word line (WLN) to allow the upper transistor to pass the write signal from the source line to the bit line; and
wherein a gate (223) of the lower transistor is connected to a second word line (WLP) to allow the lower transistor to pass the write signal from the bit line to the source line.

2. The bit cell according to claim 1, wherein each of the first word line and the second word line extends in a respective word line track arranged at the same vertical level.

3. The bit cell according to claim 1, wherein the first word line extends in a first word line track arranged at a vertical level below the channel of the lower transistor, and wherein the second word line extends in a second word line track arranged at a vertical level above the channel of the upper transistor.

4. The bit cell according to any of claims 1-3, wherein each of the bit line and the source line extends in a respective power supply track arranged at the same vertical level.

5. The bit cell according to any of claims 1-3, wherein each of the bit line and the source line extends in a respective power supply track, and wherein at least one of the power supply tracks is arranged at a vertical level below the channel of the lower transistor.

6. The bit cell according to any of the preceding claims, wherein the upper transistor is an n-type transistor, and the lower transistor is a p-type transistor.

7. The bit cell according to claim 6, wherein the upper transistor is an n-type FET, and the lower transistor is a p-type FET.

8. The bit cell according to any of the preceding claims, wherein the memory element is a resistive memory element.

9. The bit cell according to claim 8, wherein the memory element comprises a magnetic tunnel junction, MTJ, element.

10. The bit cell according to claim 9, wherein the memory element comprises the MTJ element and a spin-orbit torque, SOT track configured to switch a state of the MTJ element as the write signal passes through the SOT track.

11. The bit cell according to claim 10, wherein the memory element is configured to receive a gate voltage to modulate a magnetic anisotropy of a free layer of the MTJ element, thereby forming a voltage-gate spin-orbit torque, VGSOT, MJT device.

12. A memory device comprising an array of bit cells, each bit cell according to any of claims 1-11.

13. A method for controlling a bit cell (100), the bit cell comprising:
a non-volatile memory element (110) configured to be switchable between a first state and a second state; and
a transistor arrangement (120) configured to provide a write signal to the memory element to switch the memory element between the first state and the second state;
wherein the transistor arrangement comprises a stacked complementary transistor pair of an upper transistor (210) and a lower transistor (220), each transistor comprising a channel (214, 224) extending along a horizontal channel track (FT), the channel of the lower transistor being arranged at a first level and the channel of the upper transistor is arranged at a second level, above the first level;
wherein a first source/drain terminal (211) of the upper transistor is connected to a first source/drain terminal (221) of the lower transistor to form a first common source/drain terminal (121) and a second source/drain terminal (212) of the upper transistor is connected to a second source/drain terminal (222) of the lower transistor to form a second common source/drain terminal (122); and
wherein a first terminal (111) of the memory element is connected to a bit line (BL), a second terminal (112) of the memory element is connected to the first common source/drain terminal and the second common source/drain terminal is connected to a source line (SL);
the method comprising:
applying a first write signal to a first word line (WLN), connected to a gate (213) of the upper transistor, to pass the write signal from the source line to the bit line; and
applying a second write signal to a second word line (WLP), connected to a gate (223) of the lower transistor, to pass the write signal from the bit line to the source line.

14. A bit cell (100) comprising:
a non-volatile memory element (110); and
an access transistor arrangement (120) for controlling a write signal passing through the memory element;
wherein the access transistor arrangement comprises a stacked complementary transistor pair of an upper transistor (210) and a lower transistor (220), wherein a channel (214) of the lower transistor is arranged at a first level and a channel (224) of the upper transistor is arranged a second level, above the first level.
